# NEUE EUROPÄISCHE PATENTSCHRIFT

(11) **EP 1 510 447 B3**
(45) Veröffentlichungstag dieser Patentschrift: **17.02.2010**
(45) Hinweis auf die Patenterteilung: 18.07.2007
(21) Anmeldenummer: 04020260.8
(22) Anmeldetag: 26.08.2004
(51) Int. Cl.: B62J 6/02

(54) **Fahrradscheinwerfer**
Bicycle lamp
Phare de bicyclette

(30) Priorität: 27.08.2003 DE 20313355 U
(43) Veröffentlichungstag der Anmeldung: 02.03.2005
(73) Patentinhaber: Trelock GmbH, 48163 Münster (DE)
(72) Erfinder: Kortenbrede, Ludger, 48291 Telgte (DE); Steinkamp, Winfried, 48249 Dülmen (DE); Wissmann, Andreas, 48346 Ostbevern (DE)
(74) Vertreter: Hentrich, Swen

(56) Entgegenhaltungen:
- EP-A- 1 359 370
- DE-A- 19 842 841
- US-A- 5 641 220
- US-A1- 2001 053 077

## Beschreibung

Die Erfindung betrifft einen Fahrradscheinwerfer mit einem Gehäuse und einem Leuchtmittel, das vor einem in dem Gehäuse angeordneten Reflektor platziert ist, wobei das Leuchtmittel durch eine Licht-emittierende Diode (LED) gebildet ist.

Ein derartiger Fahrradscheinwerfer ist aus der DE 198 42 841 A1 bekannt, der aufgrund seines Betriebes insbesondere mit einer elektrischen Speicherzelle anders als bei einem von einem Dynamo gespeisten Fahrradscheinwerfer im eingeschalteten Zustand stets Licht abstrahlen und dabei auch bei einem stehenden Fahrrad die Sichtbarkeit des Fahrradfahrers als wesentlichen Sicherheitsaspekt gewährleistet. Um aufgrund der begrenzten Kapazität der elektrischen Speicherzellen sowie der Selbstentladung bei umweltfreundlichen Akkumulatoren die Leuchtdauer des Leuchtmittels zu erhöhen, ist die Verwendung der LED vorgesehen, deren Lichtaustritt entgegen der Fahrtrichtung gerichtet ist, um das emittierte Licht in den Reflektor zu leiten.

Die US 2001/0053077 A1 offenbart einen Fahrradscheinwerfer, bei dem ergänzend zu einer drahtgewendelten Glühlampe eine LED eingesetzt wird. Fahrradscheinwerfer, die über einen Dynamo betrieben werden, sind weiterhin aus Sicherheitsgründen häufig über einen Kondensator gepuffert, der allerdings bei dem erforderlichen Stromverbrauch nicht für eine lange Beleuchtung ausreicht und im Fahrbetrieb über den Dynamo nach Entleerung erst wieder geladen werden muß.

Der Erfindung liegt daher die Aufgabe zugrunde, ein Leuchtmittel bereit zu stellen, dessen Stromverbrauch bei unveränderter Leuchtkraft geringer ist, bei Beibehaltung der für den Straßenverkehr gewünschten Strahlungscharakteristik.

Diese Aufgabe wird nach der Erfindung bei einem Fahrradscheinwerfer der eingangs genannten Art dadurch gelöst, daß die LED durch eine side-emitter LED gestaltet ist.

LEDs sind aus der Praxis bekannt mit ihren günstigen Eigenschaften hinsichtlich der Leuchtkraft und des Stromverbrauchs. Jedoch hat sich bei Fahrradscheinwerfern deren Einsatz in der Praxis nicht durchgesetzt, da diese LEDs eine unzureichende räumliche Ausleuchtung bereitstellen, wenn diese wie im Stand der Technik bisher üblich direkt nach vorne abstrahlen. Erfolgt die Abstrahlung nach hinten in den Reflektor, liegt aufgrund des stark gebündelten Strahls eine große Eigenabschattung vor. Anders liegen die Verhältnisse bei der Erfindung, durch die erstmals LEDs sinnvoll bei Fahrradscheinwerfern nutzbar werden, und zwar durch die kombinierte Ausnutzung der side-emitter LEDs eigenen Abstrahlungscharakteristik, deren Licht vorteilhaft durch den Reflektor in einer praxistauglichen Weise verteilt wird, da das von der LED seitlich abgestrahlte Licht gezielt von dem Reflektor nach vorn reflektiert und auf die Fahrbahn verteilt werden kann.

Die Erfindung schlägt also erstmals vor, die side-emitter LEDs an einem Fahrradscheinwerfer mit einem Reflektor zu kombinieren, durch den es möglich ist, die mit der LED verbundenen Nachteilezu kompensieren und eine angemessene räumliche Ausleuchtung zu erreichen.

Im Rahmen der Erfindung ist weiterhin vorgesehen, daß die LED auf einem Kühlrippen aufweisenden Kühlkörper in thermischem Kontakt angeordnet ist, um so effektiv die beim Betriebe der LED entstehende Wärme abführen zu können. Zu diesem Zweck ist weiterhin vorgesehen, daß das Gehäuse aus Kunststoff gebildet ist, und daß ein durch den Kunststoff reichender Einsatz aus einem Material größerer Wärmeleitfähigkeit dem Gehäuse zugeordnet ist. Es bietet sich weiterhin an, daß am Gehäuse Kühlrippen ausgebildet sind, wobei durch diese Gestaltung auch die Voraussetzung geschaffen ist, daß die LED mehrfach vorgesehen ist und die damit verbundene sehr hohe Wärmeproduktion insgesamt beherrschbar bleibt.

Wenn die LEDs in einer ringförmigen Anordnung vor dem Reflektor positioniert sind, ergibt sich eine symmetrische Anordnung, mit der auch Reflektoren kombinierbar sind, wie diese bei punktförmigen Strahlungsquellen Anwendung finden.

Alternativ besteht auch die Möglichkeit, daß die LEDs auf dem Gitterpunkt eines Kreuzgitters angeordnet sind.

Zur einfachen Modifizierung der räumlichen Lichtverteilung besteht die Möglichkeit, daß dem Reflektor eine Streuscheibe zugeordnet ist.

Im Rahmen der Erfindung weiterhin vorgesehen ist, daß dem Reflektor eine Linse zur Projezierung des Lichtes auf die Fahrbahn zugeordnet ist. Weiterhin ist auch die Möglichkeit gegeben, daß auf der Lichtaustrittsfläche der LED eine Linse angeordnet ist, die die gewünschte räumliche Verteilung des Lichtes ermöglicht beziehungsweise unterstützt.

Auch der Einsatz von elektrischen Speicherzellen wie Akkumulatoren oder Kondensatoren ist bei dem erfindungsgemäßen Fahrradscheinwerfer prädestiniert, weil so der geringe Stromverbrauch der LED genutzt werden kann, um in jedem Betriebszustand des Fahrrades dessen Beleuchtung bereit zu stellen und auch tagsüber wie bei Motorrädern bereits üblich die Sichtbarkeit durch das Einschalten des Fahrradscheinwerfers zu erhöhen, ohne dafür durch zu schnelle Entladung der elektrischen Speicherzelle bestraft zu werden. Dafür ist das Gehäuse zur Aufnahme von mindestens einer elektrischen Speicherzelle ausgebildet.

Wegen desgeringen Stromverbrauchs der LED ist es auch möglich, daß das Gehäuse mit Fotozellen für das Laden der elektrischen Speicherzellen versehen ist, das naturgemäß aber auch konventionell durch einen Dynamo erfolgen kann, wozu dem Gehäuse ein Anschluß für eine externe Spannungsversorgung zugeordnet ist.

Es besteht auch die Möglichkeit, daß das Gehäuse eine Adapteraufnahme aufweist zum Einsetzen der einem Adapter zugeordneten LED. Der an die normierte Schnittstelle für das Einsetzen von Leuchtmittel in Fahrradscheinwerfer angepaßte Adapter bietet darüber hinaus auch die Möglichkeit, die LED mit dem Adapter in bereits existierende, konventionelle Gehäuse nach zu rüsten, insbesondere wenn dem Adapter die Bauteile zur verbesserten Wärmeabfuhr zugeordnet sind.

Im folgenden wird die Erfindung an in der Zeichnung dargestellte Ausführungsbeispiele näher erläutert; es zeigen:

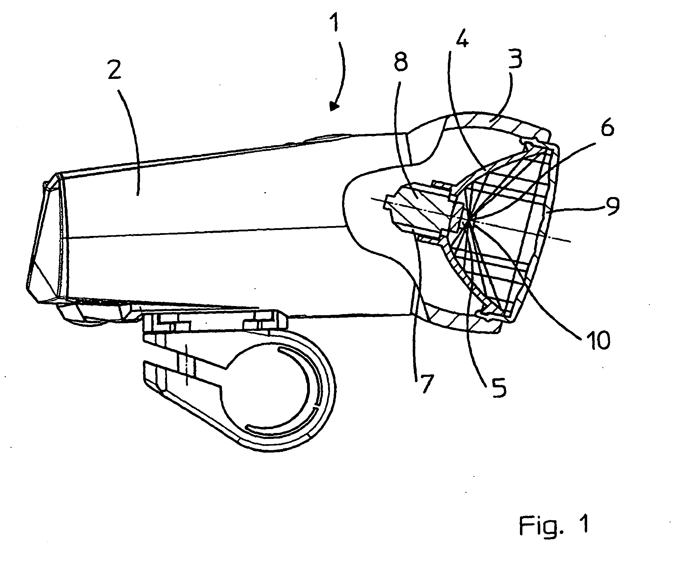

- Fig. 1: eine Seitenansicht eines erfindungsgemäßen Fahrradscheinwerfers, teilweise im Schnitt dargestellt,

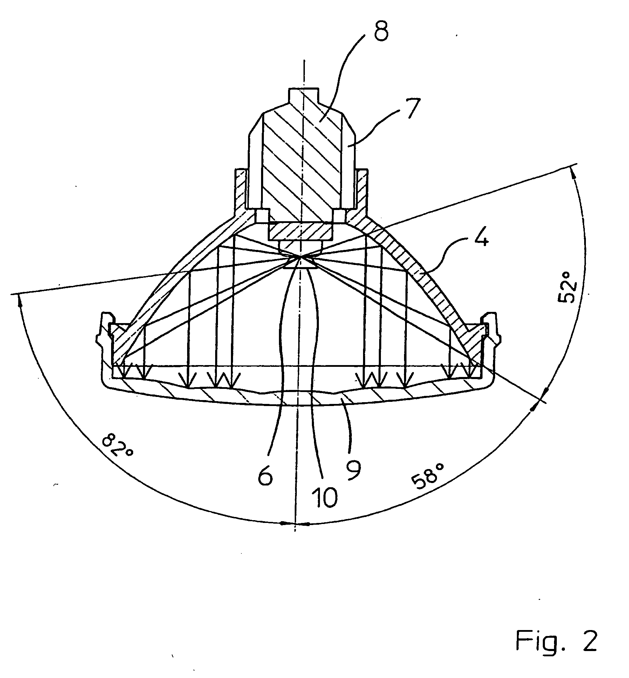

- Fig. 2: einen Schnitt durch die isolierte Darstellung des vorderen Teils des Fahrradscheinwerfers mit Reflektor und Leuchtmittel,

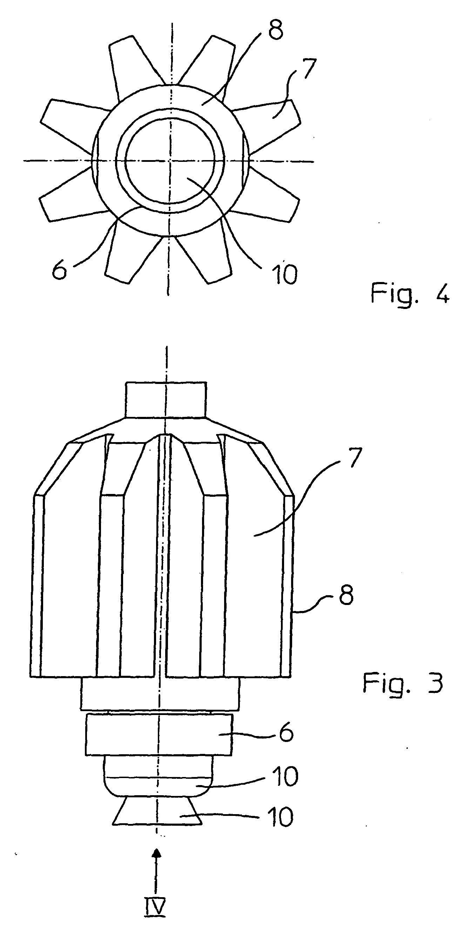

- Fig. 3: eine Seitenansicht des Kühlkörpers mit der darauf angeordneten LED,
- Fig. 4: eine Sicht aus Richtung des Pfeiles IV,

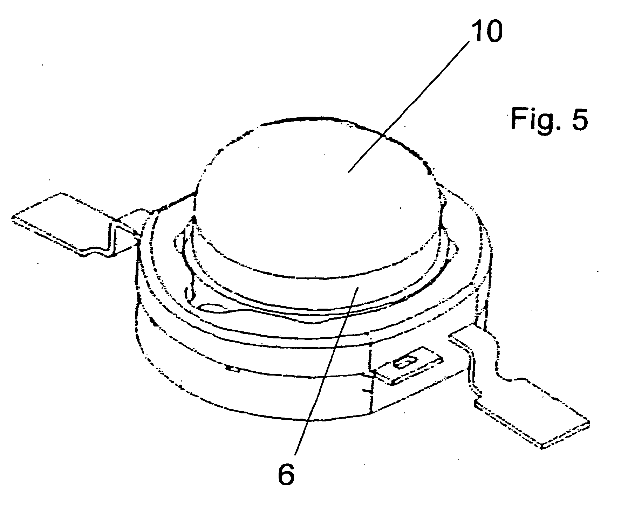

- Fig. 5: eine perspektivische Darstellung einer LED mit auf der Lichtaustrittsfläche angeordneter Linse,

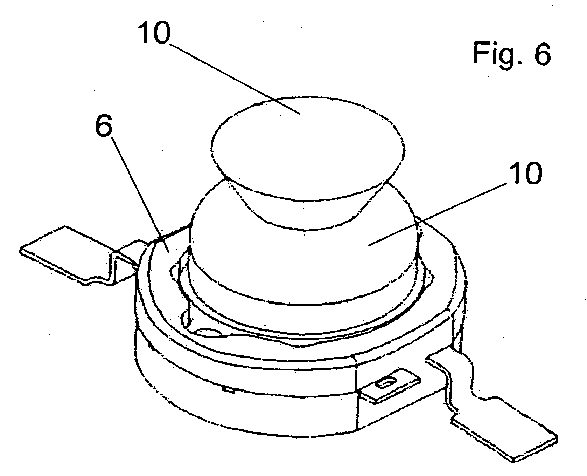

- Fig. 6: eine der Fig. 5 entsprechende Darstellung mit einer weiteren der LED zugeordneten Linse,
- Fig. 7: in einer Seitenansicht eine schematische Dar- stellung des Gegenstandes aus Fig. 6 mit an- gedeutetem Verlauf der Lichtstrahlen,
- Fig. 8: eine perspektivische Darstellung des isolier- ten Reflektors mit dem über einen Adapterein- gesetzten Leuchtmittel, teilweise geschnitten dargestellt,
- Fig. 9: eine der Fig. 8 entsprechende Darstellung mit dem das Leuchtmittel tragenden Adapter aus der Adapteraufnahme entfernt,
- Fig. 10: eine der Fig. 8 entsprechende Darstellung mit einem anderen Leuchtmittel, und
- Fig. 11: eine der Fig. 9 entsprechende Darstellung mit dem Leuchtmittel aus Fig. 10.

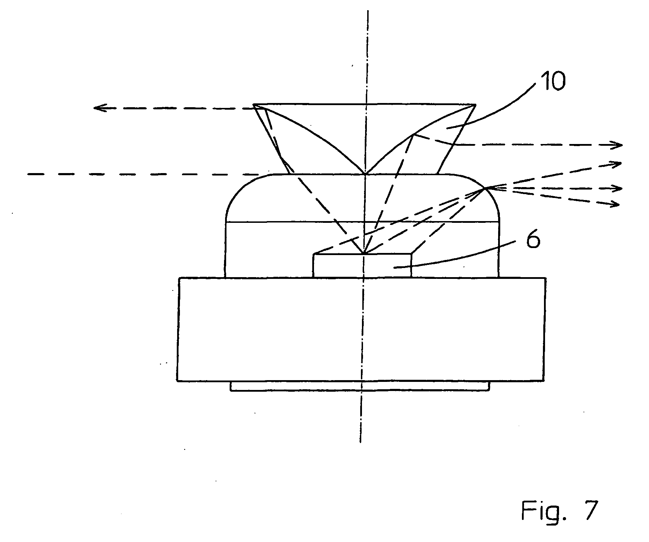

In der Zeichnung dargestellt ist ein Fahrradscheinwerfer 1, der ein Gehäuse 2 zur Aufnahme von elektrischen Speicherzellen aufweist, das bei dem in der Zeichnung dargestellten Ausführungsbeispiel mit einem separaten Gehäuseteil 3 zur Aufnahme eines Reflektors 4 und eines Leuchtmittels 5 verbunden ist. Das Leuchtmittel 5 ist durch eine Licht-emittierende Diode (LED) 6 gebildet, die in thermischem Kontakt auf einem Kühlrippen 7 aufweisenden Kühlkörper 8 angeordnet ist. Das aus Kunststoff gefertigte Gehäuse 2 weist gleichfalls Kühlrippen auf und besitzt Durchbrüche, in denen ein durch den Kunststoff reichender Einsatz aus einem Material größerer Wärmeleitfähigkeit eingesetzt ist, so daß insgesamt eine sehr große Wärmemenge effektiv aus dem Gehäuse 2 des Fahrradscheinwerfers 1 abgeführt werden kann und daher auch mehrere LEDs 6 eingesetzt werden können in einer ringförmigen Anordnung vor dem Reflektor 4 oder alternativ auf den Gitterpunkten eines Kreuzgitters. Dem Reflektor 4 ist eine Streuscheibe 9 zugeordnet und auf der Lichtaustrittsfläche der LED 6 ist eine Linse 10 platziert, die, wie in Fig. 7 dargestellt, die natürliche Strahlungscharakteristik der als side-emitter LED gestalteten LED 6 in der für einen Fahrradscheinwerfer 1 gewünschten Weise modifiziert.

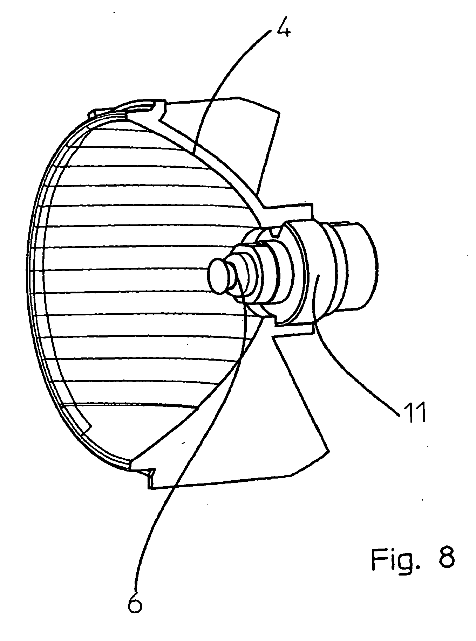

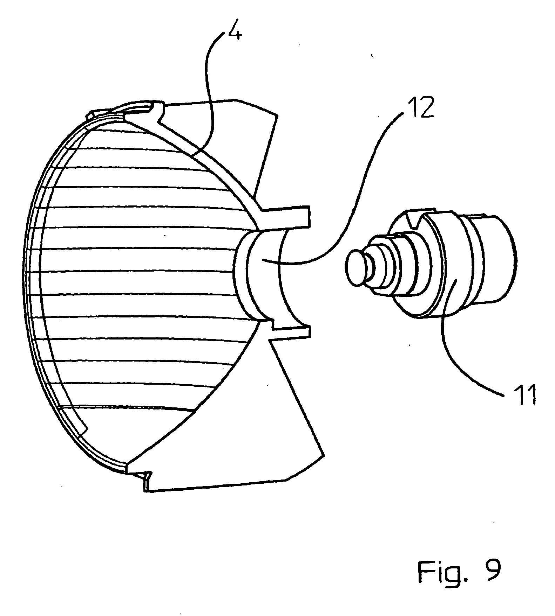

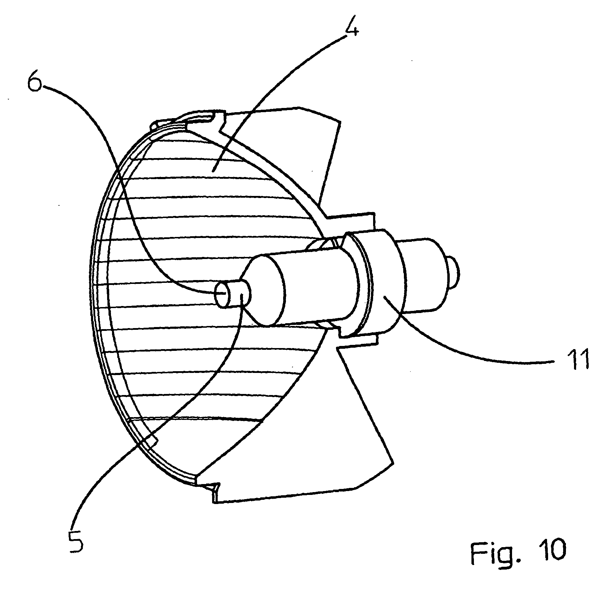

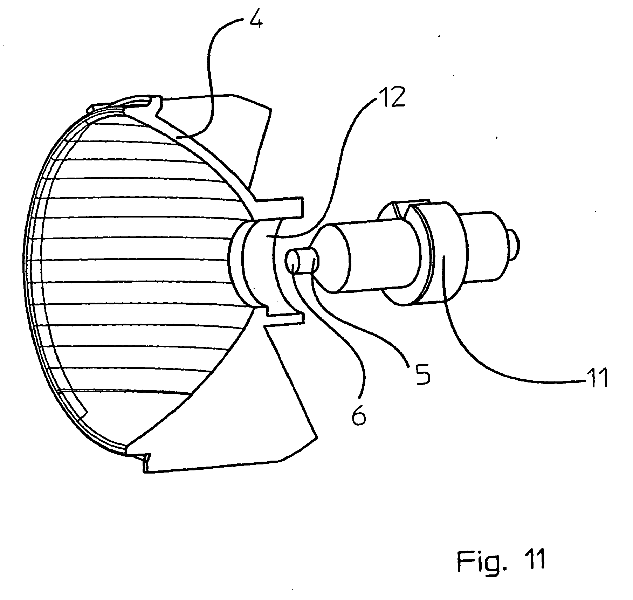

In den Figuren 8 bis 11 sind Ausführungsformen dargestellt, bei der die LED (6) bzw side-emitter LED einem Adapter (11) zugeordnet ist zum Einsetzen in eine im Gehäuse (2) ausgebildete Adapteraufnahme (12), wobei der Adapter (11) der normierten Schnittstelle zum Einsetzen von Leuchtmittel (5) in Fahrradscheinwerfer gemäß geformt ist und so auch die LED (6) als Nachrüstteil bereitstellt.

## Patentansprüche

1. Fahrradscheinwerfer mit einem Gehäuse (2) und einem Leuchtmittel (5), das vor einem in dem Gehäuse (2) angeordneten Reflektor (4) platziert ist, wobei das Leuchtmittel (5) durch eine Lichtemittierende Diode (LED) (6) gebildet ist, **dadurch gekennzeichnet, daß** die LED (6) als side-emitter LED gestaltet ist und auf einem Kühlrippen (7) aufweisenden Kühlkörper (8) in thermischen Kontakt angeordnet ist.

2. Fahrradscheinwerfer nach Anspruch 1, **dadurch gekennzeichnet, daß** das Gehäuse (2) aus Kunststoff gebildet ist, und daß ein durch den Kunststoff reichender Einsatz aus einem Material größerer Wärmeleitfähigkeit dem Gehäuse (2) zugeordnet ist.

3. Fahrradscheinwerfer nach Anspruch 1 oder 2, **dadurch gekennzeichnet, daß** am Gehäuse (2) Kühlrippen ausgebildet sind.

4. Fahrradscheinwerfer nach einem der Ansprüche 1 bis 3, **dadurch gekennzeichnet, daß** die LED (6) mehrfach vorgesehen ist.

5. Fahrradscheinwerfer nach Anspruch 4, **dadurch gekennzeichnet, daß** die LEDs (6) in einer ringförmigen Anordnung vor dem Reflektor (4) positioniert sind.

6. Fahrradscheinwerfer nach Anspruch 4, **dadurch gekennzeichnet, daß** die LEDs (6) auf den Gitterpunkten eines Kreuzgitters angeordnet sind.

7. Fahrradscheinwerfer nach einem der Ansprüche 1 bis 6, **dadurch gekennzeichnet, daß** dem Reflektor (4) eine Streuscheibe (9) zugeordnet ist.

8. Fahrradscheinwerfer nach einem der Ansprüch 1 bis 7, **dadurch gekennzeichnet, daß** dem Reflektor (4) eine Linse zur Projezierung des Lichtes auf die Fahrbahn zugeordnet ist.

9. Fahrradscheinwerfer nach einem der Ansprüche 1 bis 8, **dadurch gekennzeichnet, daß** auf der Lichtaustrittsfläche der LED (6) eine Linse (10) angeordnet ist.

10. Fahrradscheinwerfer nach einem der Ansprüche 1 bis 9, **dadurch gekennzeichnet, daß** das Gehäuse (2) zur Aufnahme von mindestens einer elektrischen Speicherzelle ausgebildet ist.

11. Fahrradscheinwerfer nach einem der Ansprüche 1 bis 10, **dadurch gekennzeichnet, daß** das Gehäuse (2) mit Fotozellen für das Laden der elektrischen Speicherzellen versehen ist.

12. Fahrradscheinwerfer nach einem der Ansprüche 1 bis 11, **dadurch gekennzeichnet, daß** das Gehäuse (2) einen Anschluß für eine externe Spannungsversorgung aufweist.

13. Fahrradscheinwerfer nach einem der Ansprüche 1 bis 12, **dadurch gekennzeichnet, daß** das Gehäuse (2) eine Adapteraufnahme (12) aufweist zum Einsetzen des einem Adapter (11) zugeordneten Leuchtmittels (5).

## Claims

1. Bicycle headlight with a housing (2) and a light source (5) which is placed in front of a reflector (4) arranged in the housing (2), wherein the light (5) is formed by a light-emitting diode (LED) (6), **characterized in that** the LED (6) is formed as a side-emitter LED and that the LED (6) is arranged on a heat sink (8) with cooling fins (7) in thermal contact.

2. Bicycle headlight according to claim 1, **characterized in that** the housing (2) is formed from plastic, and that an insert, passing through the plastic, that is made from a material having a greater thermal conductivity is allocated to the housing (2).

3. Bicycle headlight according to one of claims 1 or 2 , **characterized in that** cooling ribs are formed on the housing (2).

4. Bicycle headlight according to one of claims 1 to 3, **characterized in that** more than one LED (6) is provided.

5. Bicycle headlight according to claim 4, **characterized in that** the LEDs (6) are positioned in a circular arrangement in front of the reflector (4).

6. Bicycle headlight according to claim 4, **characterized in that** the LEDs (6) are arranged on the grid points of a cross grating.

7. Bicycle headlight according to one of claims 1 to 6, **characterized in that** a diffuser (9) is allocated to the reflector (4).

8. Bicycle headlight according to one of claims 1 to 7, **characterized in that** a lens for projecting the light onto the road is allocated to the reflector (4).

9. Bicycle headlight according to one of claims 1 to 8, **characterized in that** a lens (10) is arranged on the light-emergence surface of the LED (6)

10. Bicycle headlight according to one of claims 1 to 9, **characterized in that** the housing (2) is formed to receive at least one electrical storage cell.

11. Bicycle headlight according to one of claims 1 to 10, **characterized in that** the housing (2) is provided with photocells for charging the electrical storage cells.

12. Bicycle headlight according to one of claims 1 to 11, **characterized in that** the housing (2) has a terminal for an external power supply.

13. Bicycle headlight according to one of claims 1 to 12, **characterized in that** the housing (2) has an adapter housing (12) for inserting the light (5) allocated to the adapter (11).

## Revendications

1. Phare de bicyclette comprenant un boîtier (2) et un moyen d'éclairage (5) qui est placé devant un réflecteur (4) disposé dans le boîtier (2), le moyen d'éclairage (5) étant constitué d'une diode électroluminescente DEL (6), **caractérisé par le fait que** la diode DEL (6) est réalisée sous forme de diode à émission latérale et par la fait que la diode DEL (6) est montée sur un dissipateur de chaleur (8) doté de nervures de refroidissement (7), en étant en contact thermique avec ledit dissipateur.

2. Phare selon la revendication 1, **caractérisé par le fait que** le boîtier (2) est réalisé en matière plastique et **par le fait qu'**un insert, qui traverse la matière plastique et est réalisé à partir d'un matériau ayant une conductibilité thermique plus élevée, est associé au boîtier (2).

3. Phare selon la revendication 1 ou 2, **caractérisé par le fait que** des nervures de refroidissement sont façonnées sur le boîtier (2).

4. Phare selon une des revendications 1 à 3, **caractérisé par le fait qu'**il est prévu plusieurs diodes DEL (6).

5. Phare selon la revendication 4, **caractérisé par le fait que** les diodes DEL (6) sont disposées avec une configuration annulaire devant le réflecteur (4).

6. Phare selon la revendication 4, **caractérisé par le fait que** les diodes DEL (6) sont disposées sur les noeuds d'une grille croisée.

7. Phare selon une des revendications 1 à 6, **caractérisé par le fait qu'**une plaque de diffusion (9) est associée au réflecteur (4).

8. Phare selon une des revendications 1 à 7, **caractérisé par le fait qu'**une lentille, destinée à projeter la lumière sur la chaussée, est associée au réflecteur (4).

9. Phare selon une des revendications 1 à 8, **caractérisé par le fait qu'**une lentille (10) est disposée sur la surface de sortie de lumière de la diode DEL (6).

10. Phare selon une des revendications 1 à 9, **caractérisé par le fait que** le boîtier (2) est conçu pour recevoir au moins une cellule d'accumulation électrique.

11. Phare selon une des revendications 1 à 10, **caractérisé par le fait que** le boîtier (2) est pourvu de cellules photoélectriques destinées à charger les cellules d'accumulation électrique.

12. Phare selon une des revendications 1 à 11, **caractérisé par le fait que** le boîtier (2) présente un moyen de connexion pour une alimentation en courant externe.

13. Phare selon une des revendications 1 à 12, **caractérisé par le fait que** le boîtier (2) présente un logement d'adaptateur (12) destiné à recevoir le moyen d'éclairage (5) associé à un adaptateur (11).
